Europäisches Patentamt

European Patent Office

Office européen des brevets

(19)

(11) Veröffentlichungsnummer: **0 136 454**
**B1**

(12)

# EUROPÄISCHE PATENTSCHRIFT

(45) Veröffentlichungstag der Patentschrift:
**13.05.87**

(51) Int. Cl.⁴: **H 05 K 7/20**

(21) Anmeldenummer: **84108975.8**

(22) Anmeldetag: **28.07.84**

(54) Vorrichtung zur Wärmeabfuhr von Leiterplatten.

(30) Priorität: **30.08.83 DE 3331112**

(43) Veröffentlichungstag der Anmeldung:
**10.04.85 Patentblatt 85/15**

(45) Bekanntmachung des Hinweises auf die Patenterteilung:
**13.05.87 Patentblatt 87/20**

(84) Benannte Vertragsstaaten:
**DE FR GB**

(56) Entgegenhaltungen:
**DE - A - 2 744 341**
**DE - B - 1 243 252**
**DE - B - 2 336 168**
**DE - U - 7 740 059**
**DE - U - 8 221 756**
**FR - A - 2 413 016**
**US - A - 3 631 325**

(73) Patentinhaber: **Bodenseewerk Gerätetechnik GmbH,
Alte Nussdorfer Strasse 15 Postfach 1120,
D-7770 Überlingen/Bodensee (DE)**

(72) Erfinder: **Ohlenburger, Hans, Dahlienweg 8,
D-7770 Überlingen (DE)**

(74) Vertreter: **Weisse, Jürgen, Dipl.-Phys. et al,
Patentanwälte Dipl.-Phys. Jürgen Weisse Dipl.-Chem.
Dr. Rudolf Wolgast Bökenbusch 41 Postfach 11 03 86,
D-5620 Velbert 11 Langenberg (DE)**

## Beschreibung

Die Erfindung betrifft eine Vorrichtung zur Wärmeabfuhr von Leiterplatten, die an ihren Rändern in einem Gehäuse gehaltert sind und die auf einer Seite elektrische Bauteile tragen und auf der anderen Seite Leiterbahnen aufweisen, bei welcher

(a) die Leiterplatten auf der besagten einen Seite eine gut wärmeleitende Schicht tragen, die an den Rändern der Leiterplatte mit gegenüberliegenden ersten Wandungsteilen des Gehäuses in wärmeleitender Verbindung steht.

Die auf Leiterplatten montierten elektrischen Bauteile können erhebliche Wärme erzeugen. Diese Wärme muss abgeführt werden, um die Gefahr einer Überhitzung und damit Beschädigung der Bauteile zu vermeiden. Ein weiteres Problem ergibt sich aus der häufig erhobenen Forderung, dass das Gerät beständig gegen Schwingungen ist und bestimmte Vibrationstests übersteht. Die nur an den Rändern eingespannten Leiterplatten neigen bei bestimmten Frequenzen zu Resonanzen. Diese können die Befestigung der Bauteile auf den Leiterplatten überproportional beanspruchen und zu Ausfällen führen.

Durch die US-A-3 631 325 ist eine Leiterplattenanordnung mit einer Mehrzahl von parallel zueinander und im Abstand voneinander angeordneten Leiterplatten bekannt, die an ihren Rändern in einem Gehäuse gehaltert sind. Auf den Leiterplatten sind einzelne elektrische Bauteile angeordnet. Diese Bauteile sind in wärmeleitendem Kontakt mit Wärmeableitstreifen, die ebenfalls auf den Leiterplatten vorgesehen sind. Die Wärmeableitstreifen enden am Rand der Leiterplatte. Die Leiterplatte ist in Schlitze am Gehäuse einschiebbar, so dass die Wärme von den Wärmeableitstreifen auf das Gehäuse abgeleitet wird.

Bei dieser bekannten Anordnung erfolgt die Wärmeableitung ausschliesslich über die Ränder der Leiterplatten. Es ergibt sich weiterhin das schon oben erwähnte Problem der Resonanzschwingungen bei nur an den Rändern eingespannten Leiterplatten.

Durch das DE-U-8 221 756.4 ist eine Einrichtung zur Wärmeableitung von thermisch belasteten Halbleiterchips bekannt. Die Halbleiterchips sind dabei zwischen zwei Klötzen eingespannt, so dass ihre elektrischen Anschlüsse auf den freien Seiten zwischen den Klötzen herausragen. Diese Anschlüsse sind abgebogen und mit einer Leiterplatte verlötet. Der obere Klotz besteht aus Aluminium und ist mit einer Platte verschraubt, die mit einem Kühlprofil in Verbindung steht. Der untere Klotz besteht aus Isolierstoff. Beide Klötze sind miteinander verschraubt.

Bei dieser bekannten Anordnung wird die Wärme von jedem Halbleiterchip einzeln mittels eines wärmeleitenden Klotzes auf eine Platte übertragen. Von der Platte fliesst die Wärme in der Ebene der Platte zu deren Rand, wo dieser mit dem Gehäuse verbunden ist. Die Platte entspricht daher der wärmeleitenden Schicht üblicher Leiterplatten. Es geht um das spezielle Problem der Übertragung der Wärme von Halbleiterchips auf diese wärmeleitende Schicht.

Die DE-A-1 243 252 betrifft eine Anordnung mit einer Mehrzahl zueinander paralleler, im Abstand voneinander in einem Gehäuse gehaltener Leiterplatten. Auf jeder der Leiterplatten liegt ein wärmeleitendes Blech als wärmeleitende Schicht auf. Leiterplatte und Blech sind mit gegenüberliegenden Rändern im Gehäuse gehaltert. Das Blech überträgt dabei Wärme auf das mit Kühlrippen versehene Gehäuse. Auch hier erfolgt also der Wärmetransport nur in der Ebene der Leiterplatten bis zu deren Rändern, über welche die Wärme auf das Gehäuse abgeleitet wird.

Die FR-A-2 413 016 beschreibt eine Kühlvorrichtung für einen Halbleiterchip, wobei die Schaltverbindungen durch eine mehrlagige Leiterplatte hergestellt sind. Der Halbleiterchip sitzt dabei unmittelbar auf einem zentralen Wärmeableitblock, der mit einer Metallplatte verbunden ist. Die mehrlagige Leiterplatte ist um den Wärmeableitblock herum angeordnet und liegt auf der Metallplatte auf. Es handelt sich hier ähnlich wie bei dem DE-U-8 221 756 um die Wärmeableitung von einem einzelnen Bauelement, nämlich dem Halbleiterchip, auf die Metallplatte, welche der üblichen wärmeleitenden Schicht entspricht. Es geht nicht um die Wärmeabfuhr von dieser Schicht zum Gehäuse.

Die DE-A-2 744 341 betrifft eine Vorrichtung zur Aufnahme von Leiterplatten, bei welcher auch bei starken Beschleunigungen und Vibrationen eine Beschädigung der auf den Leiterplatten montierten Bauteile und ihrer Verbindungen vermieden wird. Dazu werden die Resonanzfrequenzen in solche Bereiche gelegt, in welchen die angreifenden Beschleunigungen einen geringen Pegel aufweisen. Dies wird dadurch erreicht, dass die Leiterplatten mit Seitenwänden verspannt sind, welche jede aus zwei miteinander vernieteten Blechen bestehen. Es erfolgt dann eine Reibungsdämpfung an den verschiedenen Berührungsflächen. Bauteile hoher Leistung, die starke Wärme erzeugen, sind gesondert auf einer Grundplatte montiert, von welcher die Wärme leichter abgeführt werden kann. Es geht hier nicht um das Problem der Wärmeleitung von Leiterplatten.

Das DE-U-7 740 059 betrifft eine Befestigungsvorrichtung zur elektrisch isolierten Befestigung von Bauelementen, die eine erhebliche Verlustwärme erzeugen. Diese Bauelemente sind einzeln durch wärmeleitende Metallteile sowie durch Verbindungselemente aus Berylliumoxid mit dem Gehäuse verbunden. Dabei sind die Verbindungselemente durch Durchbrechungen einer Leiterplatte hindurchgeführt. Hier wird die Wärme von jedem einzelnen Bauelement über das Verbindungselement unmittelbar auf das Gehäuse abgeleitet. Es erfolgt also keine Wärmeableitung über eine wärmeleitende Schicht auf der Leiterplatte.

Die DE-B-2 336 168 betrifft einen Horizontalablenk-Baustein, bei welchem eine Leiterplatte und eine Kühlfläche parallel zueinander liegend über Abstandshalter miteinander verbunden sind. Die Kühlfläche trägt ein Leistungs-Halbleiterbauelement, während die Leiterplatte weitere Bauelemente geringerer Verlustleistung trägt. Die Kühlfläche ist mit einem Metallrahmen des Fernsehempfängers verbunden.

Der Erfindung liegt die Aufgabe zugrunde, bei einer Leiterplattenanordnung der eingangs genannten Art mit wenigstens einer, mit einer wärmeleitenden Schicht versehenen und an den Rändern im Gehäuse gehalterten Leiterplatte die Wärmeableitung von der Leiterplatte zu verbessern.

Erfindungsgemäss wird diese Aufgabe mit einer Vorrichtung der eingangs genannten Art dadurch gelöst, dass

(b) in einem Mittelbereich jeder Leiterplatte ein senkrecht zur Ebene der Leiterplatte vorstehender Wärmeableitblock vorgesehen ist, über den eine zusätzliche wärmeleitende Verbindung zwischen der Leiterplatte und einem zwischen den ersten Wandungsteilen sich im wesentlichen parallel zu der Leiterplatte erstreckenden zweiten Wandungsteil des Gehäuses hergestellt ist.

Es erfolgt auf diese Weise eine Ableitung von Wärme von den elektrischen Bauteilen über die wärmeleitende Schicht einmal zu den Rändern der Leiterplatte zu gegenüberliegenden ersten Wandungsteilen des Gehäuses und zum anderen vom Mittelbereich der Leiterplatte über die Wärmeleitblöcke zu wenigstens einem zweiten Wandungsteil des Gehäuses, der in der Regel senkrecht zu den ersten Wandungsteilen verläuft. Es wird dadurch die Wärmeableitung wesentlich verbessert, da der Weg der Wärme in der wärmeleitenden Schicht verringert wird. Ausserdem wird die Stabilität der Anordnung erhöht.

Ausgestaltungen der Erfindung sind Gegenstand der Unteransprüche.

Ein Ausführungsbeispiel der Erfindung ist nachstehend unter Bezugnahme auf die zugehörigen Zeichnungen näher erläutert.

Fig. 1 zeigt im Schnitt ein Gehäuse mit darin angeordneten Leiterplatten.

Fig. 2 zeigt eine Draufsicht auf eine der Leiterplatten von der Lötseite her gesehen.

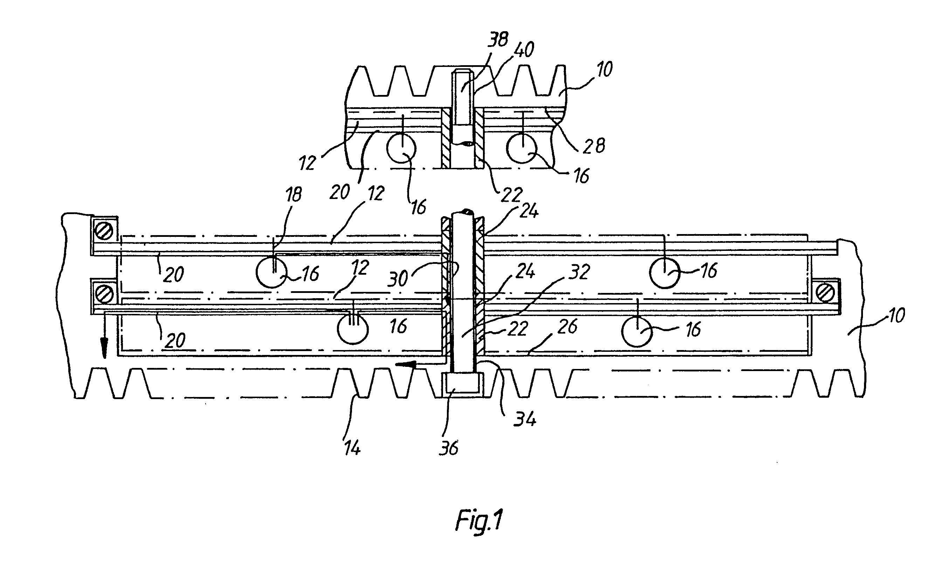

In einem Gehäuse 10 sind Leiterplatten 12 an ihren Rändern gehalten. Das Gehäuse 10 besteht aus einem gut wärmeleitenden Metall und ist mit Kühlrippen 14 versehen. Die Leiterplatten 12 tragen auf einer Seite (unten in Fig. 1) elektrische Komponenten 16. Die Komponenten 16 erstrecken sich in üblicher Weise mit Anschlussdrähten 18 durch die Leiterplatten 12 hindurch und sind auf der anderen, in Fig. 1 oben liegenden Seite (Lötseite) mit Leiterbahnen verlötet.

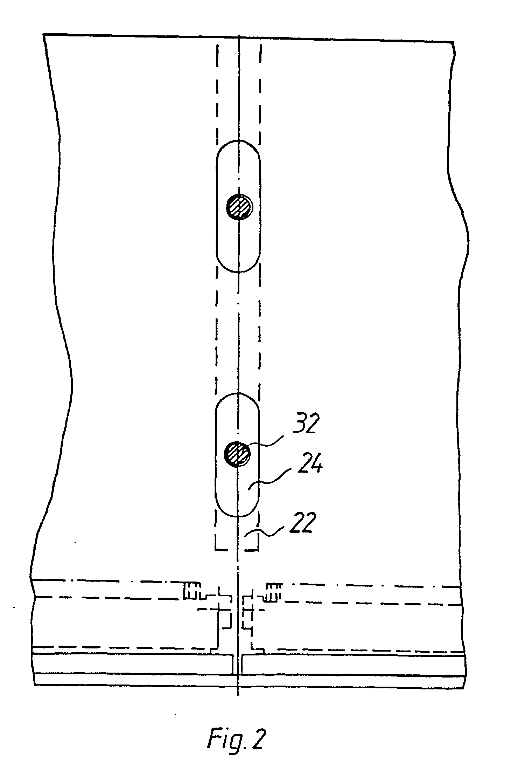

Auf der besagten Seite, aujf welcher die elektrischen Komponenten 16 sitzen, tragen die Leiterplatten 12 eine gut wärmeleitende Schicht 20. Bei der dargestellten bevorzugten Ausführung ist die wärmeleitende Schicht 20 ein Wärmeleitblech, das an der Leiterplatte 12 angebracht ist. Die wärmeleitende Schicht 20 steht über einen Wärmeleitblock 22, der in einem Mittelbereich der Leiterplatte 12 vorgesehen ist, mit dem Gehäuse 10 in zusätzlichem wärmeleitenden Kontakt. Bei der bevorzugten Ausführung ist der Wärmeleitblock 22 eine auf der Seite der wärmeleitenden Schicht 20 vorgesehene und mit dieser in wärmeleitendem Kontakt stehende Metallleiste, die sich quer über die Leiterplatte 12 erstreckt. An der Metalleiste sind Ansätze 24 vorgesehen, welche sich durch die wärmeleitende Schicht 20 und die Leiterplatte 12 erstrecken. Wie aus Fig. 2 ersichtlich ist, sind bei der bevorzugten Ausführungsform die Ansätze 24 langgestreckt, sich längs der Metalleiste erstreckend ausgebildet.

In dem Gehäuse 10 sind eine Mehrzahl von Leiterplatten 12 parallel zueinander und im Abstand voneinander angeordnet. Der Wärmeleitblock 22 jeder Leiterplatte 12 liegt an der Innenwandung 26 des Gehäuses 10 bzw. an den Ansätzen 24 des Wärmeleitblocks 22 der benachbarten Leiterplatte 12 an, wie in Fig. 1 für die obere der beiden gezeichneten Leiterplatten 12 dargestellt ist. Die Leiterplatten 12 sind zwischen und parallel zu gegenüberliegenden Innenwandungen 26 und 28 des Gehäuses 10 angeordnet. Die Endplatte auf einer Seite (die unterste Leiterplatte 12 in Fig. 1) liegt mit dem Wärmeleitblock 22 an einer Innenwand 26 des Gehäuses 10 an. Die Endplatte auf der anderen Seite (die oberste Leiterplatte 12 in Fig. 1) liegt mit den besagten Ansätzen 24 des Wärmeleitblocks 22 an der gegenüberliegenden Innenwandung 28 an. In den Wärmeleitblöcken 22 und den Ansätzen 24 der parallel übereinander angeordneten Leiterplatten 12 sind fluchtende Bohrungen 30 vorgesehen. Durch die Bohrungen sind Schraubbolzen 32 geführt. Die Schraubbolzen 32 sind durch Bohrungen 34 des Gehäuses 10 auf einer Seite hindurchgeführt und liegen mit ihren Köpfen 36 dort auf der Aussenseite des Gehäuses 10 auf. Mit Gewinden 38 sind die Schraubbolzen 32 in Gewindebohrungen 40 auf der gegenüberliegenden Seite des Gehäuses eingeschraubt. Es können dann durch Festziehen der Schraubbolzen die gegenüberliegenden Wandungen des Gehäuses 10 und die dazwischenliegenden Wärmeableitblöcke 22 gegeneinandergezogen werden, was den thermischen Kontakt verbessert. Die Wärmeableitblöcke 22 sind vorzugsweise aus Aluminium hergestellt.

**Patentansprüche**

1. Vorrichtung zur Wärmeabfuhr von Leiterplatten (12), die an ihren Rändern in einem Gehäuse (10) gehaltert sind und die auf einer Seite elektrische Bauteile tragen und auf der anderen Seite Leiterbahnen aufweisen, bei welcher

(a) die Leiterplatten (12) auf der besagten einen Seite eine gut wärmerleitende Schicht (20) tragen, die an den Rändern der Leiterplatte (12) mit gegenüberliegenden ersten Wandungsteilen des Gehäuses (10) in wärmeleitender Verbindung steht,

dadurch gekennzeichnet, dass

(b) in einem Mittelbereich jeder Leiterplatte (12) ein senkrecht zur Ebene der Leiterplatte vorstehender Wärmeableitblock (22) vorgesehen ist, über den eine zusätzliche wärmeleitende Verbindung zwischen der Leiterplatte (12) und einem zwischen den ersten Wandungsteilen sich im wesentlichen parallel zu der Leiterplatte erstreckenden zweiten Wandungsteil des Gehäuses (10) hergestellt ist.

2. Vorrichtung nach Anspruch 1 zur Wärmeabfuhr von einer Mehrzahl parallel zueinander und im Abstand voneinander angeordneter Leiterplatten (12), dadurch gekennzeichnet, dass

(a) an den auf der besagten einen Seite der Leiterplatten (12) vorgesehenen Wärmeableitblöcken (22) Ansätze (24) vorgesehen sind, welche sich durch die wärmeleitende Schicht (20) und die Leiterplatte (12) hindurch zu der anderen Seite erstrecken, und

(b) die Wärmeableitblöcke (22) mit ihren zu den Leiterplatten (12) parallelen Stirnseiten jeweils an einer Innenwandung des Gehäuses (10) bzw. an den Ansätzen (24) der Wärmeableitblöcke der jeweils benachbarten Leiterplatten (12) anliegen.

3. Vorrichtung nach Anspruch 1, dadurch gekennzeichnet, dass die Wärmeableitblöcke (22) Metalleisten sind, die sich quer über die Leiterplatten (12) erstrecken.

4. Vorrichtung nach Anspruch 2, dadurch gekennzeichnet, dass an jedem Wärmeableitblock (22) eine Mehrzahl von Ansätzen (24) vorgesehen ist.

5. Vorrichtung nach Anspruch 3, dadurch gekennzeichnet, dass

(a) die Leiterplatten (12) zwischen und parallel zu gegenüberliegenden Innenwandungen (26, 28) des Gehäuses (10) angeordnet sind und

(b) die Endplatte auf einer Seite mit dem Wärmeableitblock (22) an einer Innenwandung (26) des Gehäuses (10) und die Endplatte auf der anderen Seite mit den besagten Ansätzen (24) des Wärmeableitblocks (22) an der gegenüberliegenden Innenwandung (28) des Gehäuses (10) anliegt.

6. Vorrichtung nach Anspruch 4, dadurch gekennzeichnet, dass

(a) in den Wärmeableitblöcken (22) und den Ansätzen der parallel übereinander angeordneten Leiterplatten (12) fluchtende Bohrungen (30) vorgesehen sind und

(b) durch diese Bohrungen (30) Schraubbolzen (32) geführt sind, die durch Bohrungen (34) des Gehäuses (10) auf einer Seite hindurchgeführt sind und mit ihren Köpfen (36) dort auf der Aussenseite des Gehäuses (10) anliegen und die mit ihren Gewinden (38) in Gewindebohrungen (40) auf der gegenüberliegenden Seite des Gehäuses (10) eingeschraubt sind.

## Claims

1. Device for heat dissipation from printed circuit plates (12), which are held at their edges in a housing (10) and which carry on one side electrical components and which have strip conductors on the other side, in which

(a) the printed circuit plates (12) carry on said one side a well heat conducting layer (20), which is in heat conducting contact at the edges of the printed circuit plate (12) with opposing first wall portions of the housing (10),

characterized in that

(b) a dissipation block (22) is provided in a center area of each printed circuit plate (12) projecting perpendicularly to the plane of the printed circuit plate, through which block an additional heat conducting path is established between the printed circuit plate (12) and a second wall portion of the housing (10) extending substantially parallel to the printed circuit plate between the first wall portions.

2. Device as set forth in claim 1 for dissipating heat from a plurality of printed circuit plates (12) arranged parallelly to each other and spaced from each other, characterized in that

(a) projections (24) are provided on the dissipation blocks (22) provided on said one side of the printed circuit plates (12), which projections extend through the heat conducting layer (20) and the printed circuit plate (12) to the other side, and

(b) the dissipation blocks (22) engage with their end faces parallel to the printed circuit plates (12) an inner wall of the housing (10) or the projections (24) of the dissipation block of adjacent printed circuit plates (12), respectively.

3. Device as set forth in Claim 1, characterized in that the dissipation blocks (22) are metal ledges, which extend across the printed circuit plates (12).

4. Device as set forth in claim 2, characterized in that a plurality of projections (24) is provided on each dissipation block (22).

5. Device as set forth in claim 3, characterized in that

(a) the printed circuit plates (12) are arranged between and parallelly to inner walls on opposite sides (26, 28) of the housing (10) and

(b) the end plate, on one side with its dissipation block (22) engages one inner wall (26) of the housing (10) and the end plate on the other side with the said projections (24) of the dissipation block (22) engages the inner wall (28) on the opposite side of the housing (10).

6. Device as set forth in claim 4, characterized in that

(a) aligned bores (30) are provided in the heat dissipation blocks (22) and in the projections of the printed circuit plates (12) arranged parallel one above the other, and

(b) through these bores (30) threaded bolts (32) extend, which are passed through bores (34) of the housing (10) on one side and which there with their heads (36) engage the outer side of the housing (10) and which are screwed with their threads (38) in threaded bores (40) on the opposite side of the housing (10).

## Revendications

1. Dispositif déstiné au dissipation de chaleur de cartes de circuits imprimés (12) fixées à leurs bords dans un boîtier (10) et portant sur un côté des composants électriques et ayant sur l'autre côté des pistes conductives, dans lequel

(a) les cartes de circuits imprimés (12) portent sur ledit côté une couche à bonne conduction de chaleur (20) qui, aux bords des cartes de circuits imprimés (20), est en connexion conductrice de chaleur avec des premiers éléments de paroi opposés du boîtier (10), caractérisé par le fait que

(b) un bloc de dissipation de chaleur (22) saillant verticalement au plan de la carte de circuits imprimés est prévu dans un domaine central de chaque carte de circuits imprimés (12), une connexion conductrice de chaleur supplémentaire étant établie par l'intermédiaire de ce bloc entre la carte de circuits imprimés (12) et un deuxième élément de paroi du boîtier (10) s'étendant entre les premiers éléments de paroi essentiellement parallèlement à la carte de circuits imprimés.

2. Dispositif selon la revendication 1, destiné au dissipation de chaleur de plusieurs cartes de circuits imprimés (12) espacées et disposées parallèlement l'une à l'autre, caractérisé par le fait que

(a) des talons (24) sont prévus sur les blocs de dissipation de chaleur prévus sur ledit côté des cartes de circuit imprimés (12), et s'étendent par la couche conductrice de chaleur (20) et la carte de circuits imprimés (12) vers l'autre côté, et

(b) les blocs de dissipation de chaleur (22) avec leurs faces parallèles aux cartes de circuits imprimés (12) sont en contact respectivement avec une paroi intérieure du boîtier (10) ou avec les talons (24) des blocs de dissipation de chaleur des cartes de circuits imprimés (12) chaque fois adjacentes.

3. Dispositif selon la revendication 1, caractérisé par le fait que les blocs de dissipation de chaleur (22) sont des barres métalliques s'étendant transversalement sur les cartes de circuits imprimés.

4. Dispositif selon la revendication 2, caractérisé par le fait que plusieurs talons (24) sont prévus sur chaque bloc de dissipation de chaleur (22).

5. Dispositif selon la revendication 3, caractérisé par le fait que

(a) les cartes de circuits imprimés (12) sont disposées entre des parois intérieures (26, 28) opposées du boîtier (12) et parallèlement à celles-ci, et

(b) la plaque d'extrémité sur un côté est en contact avec le bloc de dissipation de chaleur (22) à une paroi intérieure (26) du boîtier (10) et la plaque d'extrémité sur l'autre côté est en contact avec lesdits talons (24) du bloc de dissipation de chaleur (22) à la paroi intérieure (28) opposée du boîtier (10).

6. Dispositif selon la revendication 4, caractérisé par le fait que

(a) des alésages alignés (30) sont prévus dans les blocs de dissipation de chaleur (2) et les talons des cartes de circuits imprimés (12) disposées parallèlement l'une sur l'autre, et

(b) des boulons filetés (32) sont guidés par ces alésages et par des alésages (34) du boîtier (10) sur un côté, et avec leurs têtes (36) ils sont en contact avec la face extérieure du boîtier (10) et avec leurs filets (38) ils sont vissés dans des alésages filetés (40) sur le côté opposé du boîtier (10).

Fig.1

0 136 454

Fig.2